# EUROPEAN PATENT APPLICATION

(11) **EP 1 892 047 A2**
(43) Date of publication of application: **27.02.2008**
(21) Application number: 07114936.3
(22) Date of filing: 24.08.2007
(51) Int. Cl.: B08B 7/00, H01J 37/32

(54) **Detecting the Endpoint of a Cleaning Process**

(30) Priority: 25.08.2006 US 510190
(71) Applicant: Air Products and Chemicals, Inc., Allentown, PA 18195-1501 (US)
(72) Inventor: Ji, Bing, Pleasanton,, CA 94588 (US); Motika, Stephen Andrew, Kutztown,, PA 19530 (US); Wu, Dingjun, Macungie,, PA 18062 (US); Karwacki, Jr., Eugene Joseph, Orefield,, PA 18069 (US)
(74) Representative: Muir, Benjamin M. J.

(57) **Abstract**

The endpoint of a cleaning process in which a metallic residue (40) is removed from an underlying surface (32) which comprises a metal by contacting the residue with a cleaning agent (60) which volatilizes the residue and which tends to attack the metal of the underlying surface and volatilizes it if the cleaning process is not terminated timely, and in which the metal comprising the underlying surface is more reactive with the cleaning agent than the metal of the metallic residue, is determined by detecting when the ratio of the amount of volatilized metal to the amount of cleaning agent increases from a lower to a higher value.

## Description

### BACKGROUND OF THE INVENTION

Chemical vapor deposition (CVD) is used widely in the semiconductor industry to deposit on a substrate, through the use of a precursor gas, a film, for example a film of silicon dioxide (SiO₂), of silicon nitride (Si₃N₄), or of silicon oxynitride (SiON). In the manufacture of a semiconductor integrated circuit (IC), for example, a dielectric material such as the aforementioned Si-based compounds has been used as an insulator for a transistor gate. Such insulator, which is often called a "gate dielectric", can be formed as a film in semiconductor processing chambers. In addition, materials having a relatively high dielectric constant can be used also as the barrier layer in deep trench capacitors for semiconductor memory chip manufacturing.

A state of the art CVD semiconductor processing chamber comprises typically internal aluminum walls and a support for the substrate, for example a wafer, and a port for entry of the precursor gas. During the deposition, the film is deposited not only on the intended substrate, but also on internal surfaces of the chamber and parts associated therewith, for example on walls, shields, and the substrate support. As the thickness of the film builds up, for example during subsequent depositions, the film tends to crack or peel and form particles of contaminant (for convenience, hereafter "residue") which affect adversely the substrate and film as they come in contact therewith and adhere thereto.

A dry-cleaning process using a reactive gas is used commonly to remove residue of a silicon compound (for example, polycrystalline silicon, SiO₂, SiON, and Si₃N₄) and tungsten from the parts of the chamber. These reactive gases are activated for cleaning by various types of processes. A common method is by way of using a plasma. For example, NF₃ is activated by a plasma to release free fluorine radicals. In conducting the cleaning process, it is critically important to terminate the process promptly after the residue is removed by the cleaning agent from the underlying metal surface and before the cleaning agent attacks unduly and, thus, damages parts of the chamber, for example, the internal walls thereof. The appropriate (timely) termination of the cleaning process is referred to in the art as determining the "endpoint" of the cleaning process. For a fluorine-based plasma, the endpoint of the cleaning process is determined typically by optical emission spectroscopy (OES) when the derivative of the emission intensity of fluorine changes from a strong positive value to essentially zero (that is, the point where the fluorine emission intensity curve flattens out).

The industry is moving away, however, from the use of a Si-based material as a component of a gate dielectric or other type of capacitor and toward the use of a material that has a higher dielectric constant. This movement has been triggered by the goal of the industry to produce lC devices of smaller and smaller size and the accompanying need to form thinner and thinner films of gate dielectrics. When the thickness of a gate dielectric approaches a few nanometers or less, conventional Si-based materials undergo electrical breakdown and no longer provide the desired insulation.

To maintain adequate breakdown voltage, the industry has turned to the use of materials which have a relatively high dielectric constant. The term "high dielectric constant material," as used herein, means a material whose dielectric constant is greater than 4.1 (the dielectric constant of silicon dioxide). Examples of high dielectric constant material (hereafter "HiDCM") are metal oxides, for example Al₂O₃, HfO₂, and ZrO₂ and a mixture of two or more thereof, and metal silicates, for example HfSiₓOy, and ZrSiO₄ and a mixture thereof. A film of a HiDCM is applied typically to a substrate via CVD or atomic layer deposition (ALD). Similar to the deposition of a silicon-based compound as described hereinabove, the deposition of a HiDCM in a processing chamber is accompanied by the formation on internal parts of the chamber of a metallic residue which must be removed periodically to maintain the proper operation of the film-forming process.

Also, in the fabrication of transistors using HiDCM there may also be a need to remove the material present that is not part of the gate structure (i.e., the material present in between two adjoining gates). Reactive Ion Etching (RIE) is one means for removing this material. As a result of RIE, etch residues from the process can collect onto the inner walls of the etching chamber in which the process is performed. As discussed above with respect to CVD and ALD chambers, such residues need to be removed to prevent the formation of defects.

The present invention is directed to an improved method for determining the endpoint associated with a plasma cleaning process for removing a metallic residue, particularly a residue comprising a HiDCM, which is adhered to a metallic substrate.

U.S. Patent No. 5,846,373 to Pirkle et al. disclose that the endpoint of a plasma cleaning process is considered to be reached when voltage measurements corresponding to the emission of an excited reaction product species produced in the cleaning process decreases to a substantially steady state value.

In U.S. Patent No. 6,124,927 to Zhong et al., it is disclosed that, when a silicon-based residue is removed by a plasma cleaning agent and the chamber surface is exposed to the plasma, a significant drop is observed in the intensity of the excited silicon-fluorine species formed during the process, as evidenced by optical emission; this indicates the endpoint of the cleaning process.

In the plasma cleaning process disclosed in U.S. Patent No. 6,534,007 to Blonigan, the emission intensity of free radical fluorine species in the plasma and the emission intensity of an inert background gas are both monitored. The endpoint of the cleaning process is reached when the value of a ratio of the background gas reaches the value of a predetermined ratio for a clean chamber.

U.S. Patent Application Pub. No. 2003/0221708 to Ly et al. discloses a method of removing a silicon-germanium-containing residue using hydrogen chloride gas. The presence of HCl cleaning gas and/or reaction products, such as SiCl₄ and GeCl₄, is monitored in the chamber exhaust by mass spectrometry to determine the endpoint.

Methods for removing residue comprising high dielectric constant materials from internal surfaces of CVD and ALD reactors using plasma cleaning agents such as BCl plasma are disclosed in, for example, U.S. Patent No. 7,055,263 to Wu et al., U.S. Patent Application Pub. No. US2004/0011380 to Ji et al., U.S. Patent Application Pub. No. US2004/0014327 to Ji et al., and U.S. Patent Application Pub. No. US2004/0129671 to Ji et al. During cleaning, the BCl plasma reacts with the residue and, as the end of the residue cleaning is approached, the aluminum metal surface of the reactor chamber becomes exposed to the plasma and begins to react therewith. The aforementioned publications do not disclose a technique for determining the endpoint of the cleaning process.

Unlike fluorine-based plasmas and HCl-based cleaning gases, the endpoint for removing residue comprising a HiDCM with an effective plasma cleaning agent, for example, a BCl₃-based plasma, cannot effectively be detected analogously, such as, by monitoring the emission intensity of Cl. Thus, there is a need for a method to detect the endpoint of a plasma cleaning process which involves the use of a BCl and similar plasmas.

### BRIEF SUMMARY OF THE INVENTION

In accordance with this invention, there is provided a method for monitoring and determining the endpoint of a cleaning process comprising:
(A) providing a surface: (i) which includes a metal that is capable of reacting with a cleaning agent; and (ii) which has adhered thereto residue that includes a metallic material that is capable of reacting with the cleaning agent at a rate of reaction that is slower than the rate of reaction between said metal and said cleaning agent;
(B) removing residue from the surface by contacting the residue with the cleaning agent for a period of time sufficient to volatilize the residue and form a volatilized residue product which is moved away from the surface as the product is formed;
(C) maintaining the cleaning agent in contact with the residue until the cleaning agent comes into contact with the surface by virtue of the removal of the residue and reacts with and volatilizes the metal thereof (hereafter "the volatilized metal");
(D) monitoring the amount of each of the volatilized metal and of the cleaning agent for the purpose of determining the endpoint of the cleaning process; and
(E) terminating the cleaning process at a time when the ratio of the amount of the volatilized metal to the amount of cleaning agent increases from a lower to a higher value.

In preferred form, the amount of each of the volatilized metal and the cleaning agent is monitored by the use of optical emission spectroscopy.

In preferred form, the cleaning agent is activated by a plasma.

In one embodiment of the present invention, there is provided a method in which a film comprising a metallic material having a dielectric constant greater than 4.1 is deposited onto a semiconductor substrate by chemical vapor deposition, atomic layer deposition, or RIE in a reaction chamber which includes a surface of aluminum metal which has deposited thereon during said deposition a residue comprising said metallic material, wherein after said deposition is terminated said residue is cleaned from said surface by contacting the residue with a BCl₃ cleaning agent that has been activated using, for example, a plasma, for a period of time sufficient to volatilize the residue and form a volatilized residue product which is moved away from the surface as it is formed, and wherein the cleaning agent is more reactive with the aluminum metal than with the metallic material, and wherein the amount of each of the AlCl and of the BCl is monitored for the purpose of determining the endpoint of the cleaning process, the improvement comprising terminating the cleaning process at a time when the ratio of the amount of the AlCl to the amount of BCl increases from a lower to a higher value.

Examples of metallic materials which have a relatively high dielectric constant and that can be used to form films on in a semiconductor substrate are aluminum oxide, hafnium oxide, zirconium oxide and various compounds comprising hafnium or zirconium in combination with silicon and oxygen.

Practice of the present invention can be used to avoid or minimize damage to the metallic surface to which residue adheres. Accordingly, maintenance or replacement costs of equipment used in processes involving deposition and etching of metal films on surfaces of metal can be reduced significantly.

### BRIEF DESCRIPTION OF SEVERAL VIEWS OF THE DRAWINGS

FIGS. 1A and 1B are illustrative of apparatus which are suitable for use in cleaning the chamber of a reactor using respectively an internal energy source and a remote energy source.
FIG. 2 is a graph which depicts optical emission spectra of BCl plasma cleaning agent and AlCl; and
FIG. 3 shows the time evolution of optical emission spectral intensities for AlCl, BCl, and the ratio AlCl/BCl.

### DETAILED DESCRIPTION OF THE INVENTION

The present invention has applicability to a process which involves the use of a cleaning agent to remove from a metallic surface a residue that comprises a metallic material that is less reactive with the cleaning agent than the metal comprising the metallic surface. An example of such a process involves removing residue from the surfaces of walls that form a chamber in a reactor in which chemical vapor deposition (CVD) or atomic layer deposition (ALD) is used to form a metallic film on an object, for example, a capacitor. During the use of such processes, the surfaces of the walls tend to become coated with residue which comprises constituents of the metallic film and which, if not removed periodically, causes problems of the type described hereinabove. Removal of the residue is effected by the cleaning agent which causes the residue to volatilize; the resulting vapor is moved away from the surface, for example out of the chamber of the reactor. As the residue is removed, the cleaning agent is then capable of attacking and damaging the exposed metallic surfaces of the walls comprising the chamber of the reactor.

As mentioned above, the metal comprising the surface to which the residue is adhered is more reactive with the cleaning agent than the metallic material that comprises the residue. Examples of such metals include stainless steel, hastelloy™, nickel coated carbon steel, and various alloys of alluminum. In preferred form, the metal is aluminum, preferably an aluminum alloy, for example, aluminum (6061).

The source of the residue which forms on the metallic surface can be any metallic material that is capable of being deposited as a solid film, as it is formed from a precursor gas, on an object and that is capable of reacting with the plasma cleaning agent at a rate of reaction that is slower than the rate at which a metal of the metallic surface reacts with the plasma cleaning agent.

Examples of the metallic material are a transition metal oxide, a transition metal silicate, a Group 13 metal oxide or a Group 13 metal silicate (in accordance with the IUPAC Nomenclature of Inorganic Chemistry, Recommendations 1990, Group 13 metals include Al, Ga, In, and TI and the transition metals occupy Groups 3-12). Additional examples of the metallic material are nitrogen-containing materials, for example, a nitrogen-containing transition metal oxide, a nitrogen-containing transition metal silicate, a nitrogen-containing Group 13 metal oxide, and a nitrogen-containing Group 13 metal silicate. An example of a nitrogen-containing material is a compound containing Hf, Al, O, and N. The residue can comprise a mixture of two or more of the metallic materials.

Preferably, the metallic material has a high dielectric constant, for example, a constant greater than that of silicon dioxide (that is, greater than 4.1), more preferably greater than 5, even more preferably at least 7. Examples of preferred metallic materials are Al₂O₃, HfO₂, ZrO₂, HfSiₓO_{y}, and ZrSiₓO_{y}(x is greater than 0 and y is 2x+2), and mixtures thereof.

The residue comprising the metallic material can exist in various forms, for example, as a monolithic coating or in the form of a laminate comprising two or more layers of the metallic material. Exemplary laminates comprise at least two layers of at least one member selected from the following materials: a transition metal oxide, a transition metal silicate, a Group13 metal oxide, a Group 13 metal silicate, a nitrogen-containing transition metal oxide, a nitrogen-containing transition metal silicate, a nitrogen-containing Group 13 metal oxide, and a nitrogen-containing Group 13 metal silicate. The laminate alternates preferably between at least one of the foregoing materials and, optionally, other materials such as insulating materials. For example, the laminate may be comprised of alternating layers of HfO₂ and Al₂O₃. The laminate may consist also of a certain number of layers of a first material and a certain number of layers of a second material or, alternatively, outer layers of at least one first material and inner layers of at least one second material.

The cleaning agent for use in the practice of the present invention can be any species which is capable of volatilizing the residue which is adhered to the underlying metallic surface, for example, the walls of a reaction chamber. Examples of compounds which are a source of the cleaning agent include boron (B)-containing compounds and compounds containing halogens (F, Cl, Br, and I) such as, for example, HCl, HBr, Hl, COCl₂, ClF₃, and NF_{z}Cl_{3-z}, wherein z is an integer from 0 to 3. The preferred source for the cleaning agent is the aforementioned boron-containing compound, for example, BCl₃, BBr₃, BF₃ and a mixture comprising two or more thereof. Among the foregoing, BCl₃ is the particularly preferred source of the cleaning agent and BCl is the particularly preferred species to monitor. BCl₃ is a liquefied gas at room temperature and can be delivered readily to the site of the cleaning operation, for example, a reaction chamber.

The activated form of the cleaning agent can be formed in any suitable way. For example, it can be formed from only the compound which is the source thereof or from such compound in admixture with one or more inert diluent gases, for example, nitrogen, CO₂, helium, neon, argon, krypton, and xenon. An inert diluent gas can be used, for example, to modify the plasma characteristics and cleaning process to better suit a particular application. A gaseous mixture will comprise typically 1.0 to 100 vol.% of the "compound" source and 0 to 99 vol. % of the inert gas, more typically 10 to 50 vol. % of the "compound" source and 50 to 90 vol. % of the inert gas.

The cleaning agent may be activated by subjecting one or more compounds comprising the source thereof to one or more energy sources which are effective to activate the compound(s); this can be done in the presence or absence of a diluent gas. Examples of such energy sources include plasma, α-particles,β-particles, γ-rays, x-rays, high energy electron, electron beam sources of energy; ultraviolet (wavelengths ranging from 10 to 400 nm), visible (wavelengths ranging from 400 to 750 nm), infrared (wavelengths ranging from 750 to 105 nm), microwave (frequency > 109 Hz), radiofrequency wave (frequency > 106 Hz) energy; thermal; RF, DC, arc or corona discharge; sonic, ultrasonic or megasonic energy. A mix of two or more energy sources can be used also.

As may be desired, thermal or plasma activation can be used to improve the efficacy of the cleaning of high dielectric constant residues. For thermal activation, for example, the residue-containing substrate can be heated up to 600°C, or up to 400°C, or up to 300°C at a pressure, for example, within the range of 10 mTorr (1.3 Pa) to 760 Torr (100 kPa) or 1 Torr (130 Pa) to 760 Torr (100 kPa).

The cleaning agent(s) can be formed *in situ,* that is, at the site containing the residue or at a remote site. By way of example, it is noted that BCl₃ plasma can be generated *in situ* from a mixture of BCl₃ and Helium with a 13.56 MHz RF power supply, with RF power density of at least 0.2 W/cm², or at least 0.5 W/cm², or at least 1 W/cm². *In situ* BCl₃ plasma formation can be achieved also at RF frequencies higher and lower than 13.56 MHz to enhance ion assisted cleaning of grounded ALD chamber walls. An exemplary operating pressure is generally in the range of 2.5 mTorr (0.3 Pa) to 100 Torr (13 kPa), preferably 5mTorr (0.7 Pa) to 50 Torr (7kPa), more preferably 10 mTorr (1 Pa) to 20 Torr (3 kPa). Optionally, one can also combine thermal and plasma enhancement for more effective cleaning of reactor chamber walls.

In alternative embodiments, a remote plasma source can be used in addition to or in place of an *in situ* plasma to generate the cleaning agent or to generate additional cleaning agent. In these embodiments, the remote plasma source can be generated, for example, by either an RF or a microwave source. In addition, reactions between remote plasma-generated cleaning agents and high dielectric constant materials can be activated/enhanced by heating CVD or ALD chamber components to an elevated temperature, for example, up to 600°C, or more preferably up to 400°C, or even more preferably up to 300°C.

Other means of activation and enhancement to the cleaning process can be employed also. For example, a photon-induced chemical reaction to generate a cleaning agent and enhance the cleaning reaction can be used.

In addition to being thermodynamically favorable, a chemical reaction often requires an external energy source to overcome an activation energy barrier so that the reaction can proceed. The external energy source can be, for example, thermal heating or plasma activation. Higher temperatures can accelerate chemical reactions and make reaction byproducts, for example, a volatilized residue product, more volatile. However, there may be practical limitations on temperature in production deposition chambers. Plasmas can generate more cleaning agents to facilitate reactions. Ions in the plasmas are accelerated by the electric field in the plasma sheath to gain energy. Energetic ions impinging upon surfaces can provide the energy needed to overcome reaction activation energy barrier. Ion bombardment helps to also volatilize and remove reaction byproducts. These are common mechanisms in plasma cleaning and reactive ion etching.

The cleaning agent is preferably maintained in contact with the residue for as long as it takes to volatilize the residue. Such contact time will depend on various factors, for example, the nature of the constituents that comprise the residue, the composition of the plasma cleaning agent, and the thickness and other physical characteristics of the residue. Speaking generally and by way of example, the contact time can fall within the range of 10 seconds to 60 minutes depending upon the amount of residue that has coated the chamber walls.

Any suitable means can be used to monitor the amount of each of the volatilized metal and of the plasma cleaning agent in the vapor which contains these materials. Such monitoring can involve either direct or indirect evaluation of the amounts. As explained below in connection with the description of a preferred embodiment of the present invention, the preferred method for the monitoring operation involves the use of optical emission spectroscopy (OES). Other exemplary "monitoring" means are UV-VIS absorption spectroscopy, microwave absorption spectroscopy, near infrared spectroscopy, infrared spectroscopy, and mass spectrometry.

Set forth hereafter is additional information related to a preferred embodiment of the present invention for determining the endpoint of a cleaning process in which the residue is adhered to a surface of metal which includes aluminum, the residue comprises a metallic material of aluminum oxide. BCl is a species created from BCl₃ by the plasma, AlCl is a species created by the plasma from AlCl₃, which is the volatile form a aluminum chloride from the substrate surface.

In forming *in situ* a plasma from BCl₃, the predominant reactive species in the bulk of the plasma is BCl (boron monochloride). Without being bound by a particular theory, it is believed that BCl can be produced via electron-molecule collisions in the plasma pursuant to the following reaction

(1) BCl₃ + e⁻ →BCl + Cl₂ + e⁻

or by dissociative ionization according to the following reactions

(2) BCl₃ + e⁻ → BCl + Cl₂⁺ + 2e⁻ and

(3) BCl₃ + e⁻ → BCl⁺ + Cl₂ + 2e-.

BCl⁺ ions can recombine with electrons to form excited BCl according to the reaction

(4) BCl⁺ + e⁻ → BCl*.

In addition, ground state BCl can be excited directly by collision with electrons pursuant to the reaction

(5) BCl + e⁻ → BCl* + e⁻.

The excited BCl* can give off by radiation its energy and return to ground state via the reaction

(6) BCl* → BCl + hv.

The optical emission process shown in equation (6) gives the characteristic emission of BCl A ¹Π- X ¹Σ⁺ emission at 272 nm.

Under higher resolution, this optical emission spectrum can be resolved into a triplet structure with three peaks at 272.00, 272.17, and 272.22 nm respectively. These are emissions from different ro-vibrational bands. For the purpose of this invention, the unresolved peak intensity at lower spectral resolution can be used. Alternatively, one of the resolved triplet peak intensity at higher spectral resolution can be used or the average intensity of the three resolved peaks can be used.

Among the dissociative fragments of BCl₃ in a plasma, BCl appears to be the most effective agent to react with high dielectric constant materials, for example, Al₂O₃, HfO₂, and ZrO₂. Without being bound by a particular theory, it is believed that BCl is particularly effective because there is a synergistic reaction between two chemical processes, namely the removal of oxygen that assists the breaking of metal oxygen bonds and the formation of volatile metal chlorides, for example,

(7) Al₂O₃ + BCl → AlCl₃+ B₂O₃,

(8) HfO₂ + BCl → HfCl₄ + B₂O₃,

and

(9) ZrO₂ + BCl → ZrCl₄ + B₂O₃.

During an *in situ* cleaning process, the cleaning agent is consumed by an etch reaction such as exemplified by equations (7) through (9) above, and replenished at the same time by reactions such as those shown in equations (1) through (3) above.

Without being bound by a particular theory, when the metallic material residue is removed from the metal surface to which it is adhered (for example, the walls of a reactor chamber), the metal surfaces of the chamber are exposed to the plasma. Aluminum alloy, particularly aluminum (6061), is one of the most common materials of construction for deposition chambers. When aluminum is exposed to a plasma formed from BCl₃, etching reactions occur, for example,

10) (Al + BCl → AlCl₃ + B.

Similar to BCl, AlCl radicals can be excited also to higher energy states, for example, by the reaction

(11) AlCl₃ + e⁻ → AlCl* + Cl₂ + e⁻.

The excited AlCl* then undergoes spontaneous radiative decay A¹Π- X¹Σ⁺ at 261.44 nm.

The reaction between aluminum alloy and BCl, for example, equation (10) above, proceeds at a higher rate than the reactions between the metallic material residue and BCl, for example, equations (7) through (9) above. Although the production of BCl is relatively constant via reactions (1) through (3) above, the higher etch rate of the aluminum alloy in reaction (10) results in a lower BCl density in the plasma. In addition, the higher rate of reaction in the etching of aluminum results also in an increase in the density of AlCl in the plasma. The increase in the AlCl density in the plasma is not particularly dramatic because of the initial presence in the plasma of AlCl as a result of the volatilization of the Al-containing residue. However, in a process in which the residue does not contain aluminum, for example, hafnium oxide, the sudden surge of AlCl in the plasma is indeed dramatic as the underlying aluminum metal is etched and volatilized by the plasma upon the removal of the residue and contact therewith.

The changes in the chemical compositions of the plasma as the cleaning process approaches its endpoint induce changes in the optical emission spectra of the components comprising the plasma. Before reaching the endpoint, the relatively high BCl density leads to stronger optical emission intensity at its characteristic 272 nm. As the cleaning process approaches its endpoint, lower BCl density leads to weaker BCl optical emission at 272 nm. At the same time, the emergence or the increase of AlCl density in the plasma leads to appearance or increase of AlCl optical emission at 261 nm. Therefore, changes in the intensities of the characteristic optical emission features of BCl at 272 nm and AlCl at 261 nm can be used as an indicator of the endpoint of the cleaning process.

Thus, a preferred embodiment of the present invention includes monitoring the amount of each of the volatilized metal and the plasma cleaning agent by the use of optical emission spectroscopy (OES). The plasma constituents (including BCl, volatilized residue products, and volatilized metal chlorides) are excited continuously by electrons and collisions in the plasma and give off emissions ranging from ultraviolet to infrared radiation as they relax to a lower energy state. An optical emission spectrometer is used to diffract the emissions into component wavelengths, for example, BCl emission at 272nm and volatilized metal chlorides, for example, AlCl emission at 261 nm. The optical emission spectrometer is used also to determine the intensity of the AlCl emission and the intensity of the BCl emission, each of which is proportional to the concentration of each species. A ratio of the intensity of the AlCl emission to the intensity of the BCl emission is monitored. The endpoint is reached when the ratio increases from a lower to a higher value.

In general, determining the ratio based on the intensity of a constituent whose emission intensity is increasing (for example, AlCl) and the intensity of a constituent whose emission intensity decreasing (for example, BCl) towards the endpoint of the cleaning process enhances greatly the detection sensitivity. This is an improvement relative to the use only of the intensity of one of the OES peaks or the ratio between an OES peak and the OES background, or the ratio between one OES peak from a reactive species (for example, F) and an inert background gas (for example, argon actinometer).

Emission intensity can be detected in OES by utilizing a multi-channel detector, for example, a charge-coupled device ("CCD") or photodiode array ("PDA"), which has the advantage of simultaneous detection of all the spectral features. A scanning type spectrometer to record OES can be used also. Alternatively, a combination of narrow band filters and photo detector to selectively detect I(AlCl) and I(BCl) intensities can be used. For example, in certain embodiments, a narrow band filter centered at 261 nm with a full width at half maximum (FWHM) of 3 nm may be used to select an AlCl emission and a narrow band filter centered at 272 nm with a FWHM of 3 nm to select BCl emission. The selected optical emission can be detected by a photon sensor, for example, a photodiode or a photomultiplier tube. The use of narrow band filter/photodiode combination may offer one or more of the following advantages: low cost, field robustness, rapid response, and/or ease of integration into the process reactor for automatic endpoint detection and process control. The center wavelength and the bandwidth of the spectral filters should be selected to capture the maximum intensity of the desired peak without interference from nearby unwanted peaks.

In certain embodiments, data manipulation methods, for example, using the derivative of the intensity ratio I(AlCl)/I(BCl) can also be applied to locate the cleaning endpoint. Furthermore, alternative detection methods such as mass spectrometry are useful for detecting AlCl and BCl when alternative methods for activating the cleaning process such as remote plasma and thermal or UV activation are used.

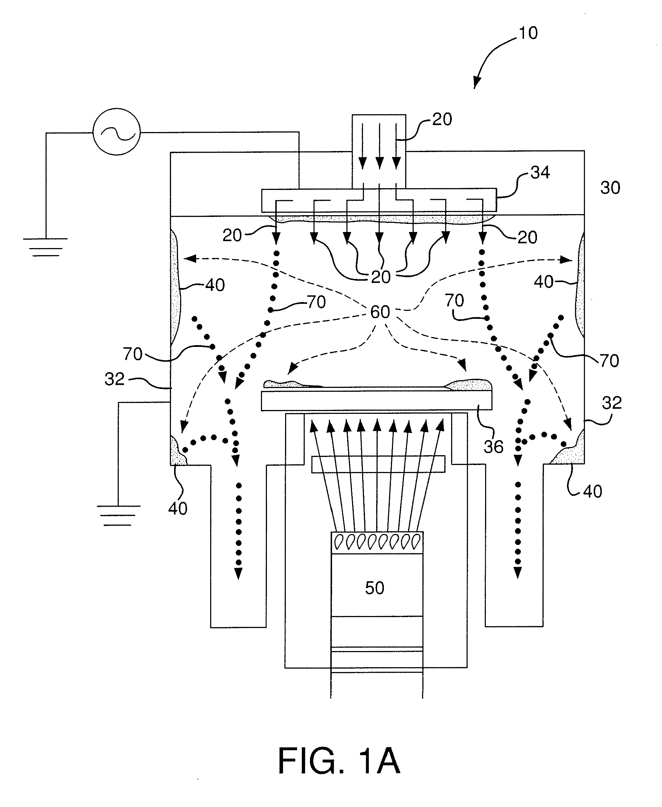

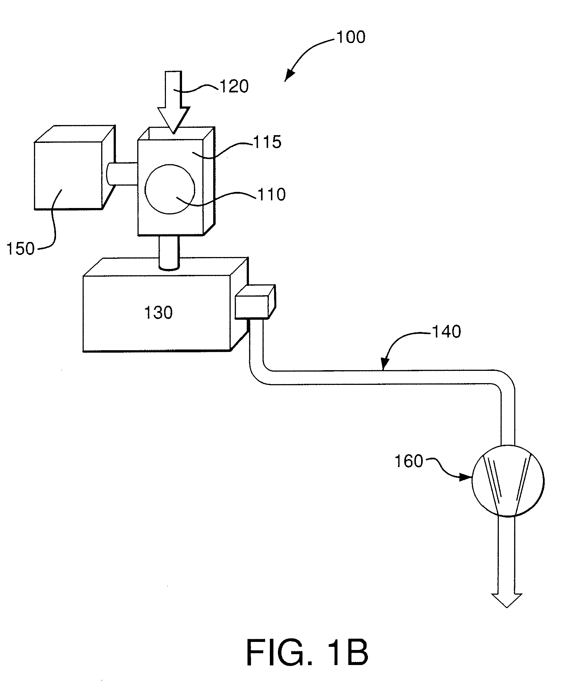

FIGS. 1A and 1B provide an illustration of an apparatus 10 which is suitable for performing chamber cleaning using an internal energy source such as an *in situ* plasma or a thermal source or an external energy source respectively. In FIG. 1A, the cleaning agent source 20 (BCl₃-depicted in FIG. 1A as solid arrows) is introduced into the reaction chamber 30 which has a residue 40 of metallic material to be removed. As shown in FIG. 1A, the residue 40 is deposited upon at least a portion of the exposed surface within the reaction chamber 30, particularly, the grounded sidewalls 32, showerhead 34, and work piece platform 36. The cleaning agent source 20 is exposed to an energy source 50, for example, an RF power supply or heater which converts the source, for example BCl₃, of the cleaning agent to the cleaning agent 60, for example BCl, shown by the dashed arrows. The cleaning agent 60 reacts with residue 40 and forms a volatilized residue product 70. The volatilized residue product 70 is removed from the chamber 30 as shown by the dotted arrows.

FIG. 1B provides an example of an apparatus 100 in which the cleaning agent source 120, for example BCl₃, is exposed to an external energy source 150, for example a microwave source, to produce a high density plasma 110 of the cleaning agent within an applicator/resonant cavity 115. The high density plasma 110 can then be transported to the reaction chamber 130 containing the residue to form the volatilized residue product (not shown). The volatilized residue product can be removed readily from the chamber 130, aided by use of pump 160, via the foreline 140.

Additional objects, advantages, and novel features of this invention will become apparent to those skilled in the art upon examination of the following examples thereof, which are not intended to be limiting.

### EXAMPLES

The following examples are designed to represent conditions that are present during the cleaning of a reaction chamber with a BCl plasma cleaning agent. Test coupons made of aluminum metal simulate the metal surface of the reaction chamber. Test coupons that are covered with an Al₂O₃ film simulate a metallic material residue on the surface of a reaction chamber. The test coupons are placed on an RF-powered lower electrode in a modified parallel plate Gaseous Electronics Conference (GEC) reactor and exposed to a BCl plasma cleaning agent which is formed from BCL₃. The plasma cleaning agent reacts with the Al₂O₃ film and the aluminum metal of the test coupons to produce respectively a volatilized residue product (AlCl) and a volatilized metal (AlCl).

Optical emission spectroscopy is used to monitor the presence of AlCl and BCl in the GEC reactor. Optical emission spectra (OES) are recorded in a capacitatively coupled BCl plasma. The plasma conditions are: 10 sccm (standard cubic centimeters, i.e. cm³ at standard temperature and pressure) BCl₃ flow, 500 mTorr (67 Pa) chamber pressure, and 100 W RF power at 13.56 MHz. OES are recorded by an optical fiber coupled charge-coupled device (CCD) array spectrometer (Ocean Optics S2000). The OES peak which is associated with the presence of AlCl appears at the wavelength of 261 nm. The OES peak which is associated with the presence of BCl appears at the wavelength of 272 nm. The OES intensity which is representative of the amounts of AlCl and BCl present is given in arbitrary units.

### Example No. 1

The OES of each of a test coupon coated with an Al₂O₃ film and of an uncoated test coupon is compared. In the first run, a test coupon coated with an Al₂O₃ film by atomic layer deposition (ALD) is loaded into the GEC reactor. OES are recorded as the Al₂O₃ film is removed from the surface of the coupon by the cleaning agent. In the second run, an uncoated aluminum metal sample is loaded into the reactor. OES are recorded as the aluminum metal is etched by the BCl cleaning agent. In each of the runs, OES are recorded also for BCl.

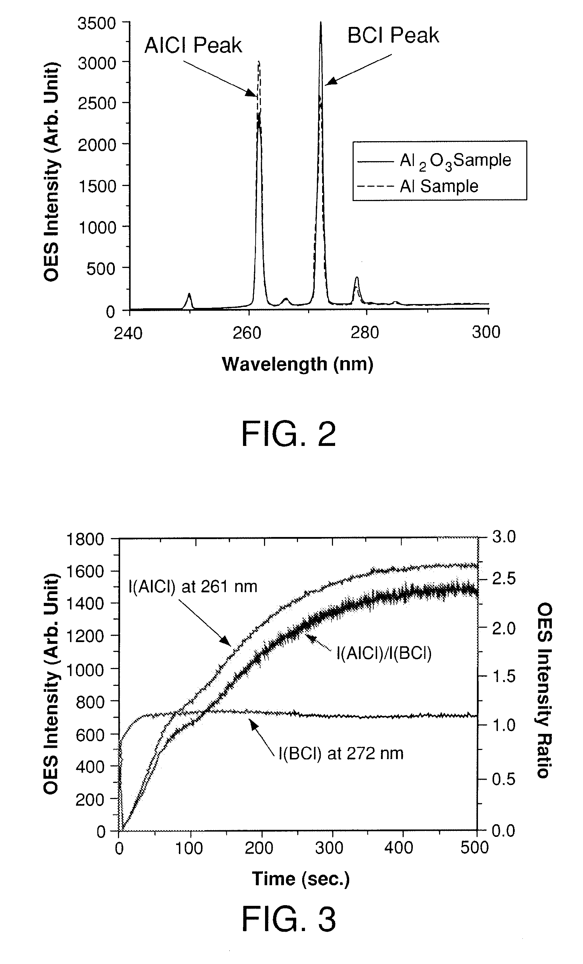

Figure 2 shows an overlay of the OES from both runs to provide a comparison of peak intensities between the two runs for both AlCl and BCl. The spectrum indicated as the solid line represents the spectrum obtained in the first run with the test coupon coated with an Al₂0₃film. The spectrum indicated as the dotted line (---) represents the spectrum obtained in the second run with the uncoated aluminum metal test coupon.

As shown in Figure 2, AlCl emission at 261 nm and BCl emission at 272 nm which identify the presence of these materials are observed in both sets of runs. When the aluminum metal test coupon coated with an Al₂O₃ film is the sample, the BCl emission intensity (I(BCl)) at 272 nm is more than that of the AlCl emission intensity (I(AlCl)) at 261 nm.

Table 1 lists the OES intensities and the intensity ratio between the AlCl emission at 261 nm and the BCl emission at 272 nm for these two runs.

**TABLE 1**

| Sample | I(AlCl @261 @ 261 nm) | I(BCl @ 272 nm) | I(AlCl)(BCl) |
|---|---|---|---|
| Al₂O₃ | 2331 | 3458 | 0.67 |
| Al | 2983 | 2375 | 1.26 |

As shown in Table 1, the I(AlCl)/I(BCl) ratio is 0.67 when etching the Al₂O₃ film and 1.26 when etching the aluminum metal sample. Some of the reactor internal components (e.g. showerhead) are made of aluminum alloy. This contributes to the baseline AlCl peak level in the data. For a reaction chamber having internal surfaces completely coated with an Al2O3 residue, the contrast in OES intensity ratio of I(AlCl)/I(BCl) will be more significant as the Al₂O₃ residue is removed and the more reactive aluminum alloy is exposed to BCl plasma.

### Example No. 2

The time evolution of I(AlCl) and I(BCl) and their ratio are measured to monitor the progression of a cleaning process. A test coupon coated with an Al₂O₃ film is loaded into the reactor as described above. The plasma recipe is the same as for Example No. 1. OES is continuously recorded when the BCl plasma is turned on. Figure 3 shows the OES intensities I(AlCl) as a function of time (seconds). At first, the BCl plasma cleaning agent removes the Al₂O₃ film on the sample and the native Al₂O₃ on surfaces of the internal aluminum components in the reactor. As Al₂O₃ is removed and the aluminum metal is exposed to the BCl cleaning agent, I(BCl) at 272 nm decreases and I(AlCl) at 261 nm increases. As a result, the ratio I(AlCl)/I(BCl) increases. This is shown as an inflection point in Figure 3 at approximately 90 seconds and represents the end point of the cleaning process. Eventually, when all of the Al₂O₃ is removed, I(AlCl), I(BCl), and the ratio I(AlCl)/I(BCl) all reach a steady state. For a reaction chamber having internal surfaces completely coated with an Al₂O₃ residue, the change (or the turning point) in the intensity ratio I(AlCl)/I(BCl) will be more dramatic as the cleaning process approaches the endpoint. The usual data manipulation methods, such as using the derivative of the intensity ratio I(AlCl)/I(BCl), can also be applied to locate the cleaning endpoint.

The foregoing examples and description of the preferred embodiments should be taken as illustrating, rather than as limiting the present invention as defined by the claims. As will be readily appreciated, numerous variations and combinations of the features set forth above can be utilized without departing from the present invention as set forth in the claims. Such variations are not regarded as a departure from the scope of the invention, and all such variations are intended to be included within the scope of the following claims.

## Claims

1. A method for monitoring and determining the endpoint of a cleaning process for cleaning a surface: (i) which comprises a metal that is capable of reacting with a cleaning agent; and (ii) which has adhered thereto residue that comprises a metallic material that reacts with said cleaning agent at a rate of reaction that is slower than the rate of reaction between said metal and cleaning agent; the method comprising
(A) removing at least a portion of said residue from said surface by contacting the residue with the cleaning agent for a period of time sufficient to volatilize residue and form a volatilized residue product which is moved away from the surface as the product is formed;
(B) maintaining the cleaning agent in contact with the residue until the cleaning agent comes into contact with the surface, by virtue of the removal of residue, and reacts with and volatilizes the metal thereof to form a the volatilized metal;
(C) monitoring the amount of each of said volatilized metal and said cleaning agent for the purpose of determining the endpoint of the cleaning process; and
(D) terminating the cleaning process at a time when the ratio of the amount of the volatilized metal to the amount of cleaning agent increases from a lower to a higher value.

2. The method of Claim 1, wherein the cleaning agent is a plasma activated cleaning agent.

3. The method of any preceding claim, wherein said surface comprises at least a portion of an interior surface of a reaction chamber.

4. The method of Claim 3, wherein said interior surface comprises a wall.

5. The method of Claim 3 or 4, wherein said cleaning agent is generated inside said reaction chamber.

6. The method of Claim 3 or 4, wherein said cleaning agent is generated outside said reaction chamber.

7. The method of Claim 5, further comprising delivering a cleaning agent source to said reaction chamber prior to forming said cleaning agent.

8. The method of Claim 7, wherein said cleaning agent source is selected from BCl₃, BBr₃, Bl₃, BF₃, and mixtures thereof.

9. The method of Claim 8, wherein said cleaning agent source is BCl₃.

10. The method of any preceding claim, wherein said metal is selected from aluminum and an aluminum alloy.

11. The method of any preceding claim, wherein said metallic material is selected from one or more of aluminum oxide, hafnium oxide, zirconium oxide, HfSiₓO_{y}, and ZrSiₓO_{y}, wherein x is greater than 0 and y is 2x + 2.

12. The method of any preceding claim, wherein said volatilized metal is activated to create a volatile leaving group and is subsequently monitored by monitoring the volatile leaving group.

13. The method of Claim 12, wherein the volatile leaving group is AlCl.

14. The method of any preceding claim, wherein said cleaning agent comprises BCl.

15. The method of Claim 14, wherein the BCl is created by activating BCl₃.

16. The method of any preceding claim, wherein:
(A) said metal comprises aluminum;
(B) said metallic material is selected from one or more of aluminum oxide, hafnium oxide, zirconium oxide, HfSiₓO_{y}, ZrSiₓO_{y}, wherein x is greater than 0 and y is 2x + 2;
(C) said volatilized metal is activated to create AlCl; and
(D) said cleaning agent comprises BCl.

17. The method of any preceding claim, wherein the amount of each of the volatilized metal and the cleaning agent is monitored by the use of optical emission spectroscopy.

18. The method of Claim 17, further comprising monitoring the derivative of a spectrum obtained by the use of optical emission spectroscopy.

19. The method of any preceding claim, wherein the cleaning agent is present as an admixture of said cleaning agent and an inert diluent gas.

20. The method of Claim 19, wherein said inert diluent gas is selected from nitrogen, CO, helium, neon, argon, krypton, and xenon.

21. A method in which a film comprising a metallic material having a dielectric constant greater than 4.1 is deposited onto a semiconductor substrate by chemical vapor deposition, atomic layer deposition, or RIE in a reaction chamber which includes a surface of aluminum metal which has deposited thereon during said deposition a residue comprising said metallic material, wherein after said deposition is terminated at least a portion of said residue is cleaned from said surface by contacting the residue with a cleaning agent, comprising BCl₃ that has been activated using a plasma, for a period of time sufficient to volatilize the residue and form a volatilized residue product which is moved away from the surface as it is formed, and wherein the cleaning agent comes into contact with the surface by virtue of the removal of the residue and reacts with the aluminum metal to form AlCl, and wherein the cleaning agent is more reactive with the aluminum metal than with the metallic material, and wherein the amount of each of the AlCl and of the BCl is monitored for the purpose of determining the endpoint of the cleaning process, comprising terminating the cleaning process at a time when the ratio of the amount of the AlCl to the amount of BCl increases from a lower to a higher value.

22. The method of Claim 21 wherein the amount of each of the AlCl and BCl is monitored by the use of optical emission spectroscopy.
